# EUROPEAN PATENT SPECIFICATION

(11) **EP 0 614 497 B1**
(45) Date of publication and mention of the grant of the patent: **08.10.1997**
(21) Application number: 93915843.2
(22) Date of filing: 07.07.1993
(51) Int. Cl.: C23C 16/04, C23C 16/44, C23C 16/46

(54) **APPARATUS AND METHOD FOR TREATING A WAFER OF SEMICONDUCTOR MATERIAL**
VORRICHTUNG UND VERFAHREN ZUR BEHANDLUNG EINES WAFERS AUS HALBLEITER-WERKSTOFF
APPAREIL ET PROCEDE DE TRAITEMENT D'UNE TRANCHE EN MATERIAU SEMI-CONDUCTEUR

(30) Priority: 07.07.1992 NL 9201211
(43) Date of publication of application: 14.09.1994
(73) Proprietor: COBRAIN N.V., B-3030 Heverlee (BE)
(72) Inventor: BRASSEUR, Guy Jean Jacques, B-3307 Tienen (BE)
(74) Representative: Land, Addick Adrianus Gosling
(86) International application number: EP9301779
(87) International publication number: WO9401597

(56) References cited:
- EP-A- 0 467 624
- US-A- 5 060 354
- PATENT ABSTRACTS OF JAPAN vol. 6, no. 202 (C-129)(1080) 13 October 1982 & JP,A,57 110 665 (SUWA SEIKOSHA) 9 July 1982
- PROCEEDINGS OF SPIE vol. 631 , 1986 , WASHINGTON, US pages 34 - 39 COOPMANS AND ROLAND 'DESIRE: a novel dry developed resist system' cited in the application

## Description

Arranging an image on the top surface of resist material is becoming increasingly popular and is known as Top Surface Imaging (TSI), as for instance the Desire^{R} process described in Proceedings SPIE 631, page 34 (1986) by F. Coopmans and B. Roland. In addition to dry developing of the image, which must take place rapidly and anisotropically, the depositing of a silylation agent such as hexamethyldisilazane or trimethyldisilazane is also important. This must take place in a properly uniform manner while depth and profile of the indifusion of this silylation agent must be precisely determined. Further information cn be obtained from the above article.

In such processes the problem occurs that the temperature in a reactor in which such a process has to take place is difficult to keep constant. So called hot spots are to be avoided and atmospheric influence is to be minimised.

US-A-5,060,354 discloses a heated plate rapid thermal processor, which is suitable for treating wafers.

The present invention provides a method for treating a wafer of semiconductor material at a predetermined temperature with gas and/or vapour, comprising:
- supplying a wafer of semiconductor material in a supply lock;
- placing the wafer of semiconductor material in a treatment space via the supply lock;
- admitting gas and/or vapour into the treatment space through a gas inlet;
- bringing the treatment space to and holding it at underpressure by pump means; and
- heating the wafer of semiconductor material by heating means provided to a table part for supporting said wafer, wherein a temperature stability within 1°C is obtained in a temperature range of 30 - 250°C as the table part has a high mass and a heat capacity at least two orders of magnitude larger than a semiconductor wafer and wherein the gas is supplied through the underside of the table part and the pump means are connected through the upper wall of said apparatus, substantially opposite the gas supply and above said table part.

The gas inlet is situated on the rear side of the wafer of the semiconductor to be positioned so that there is no possibility that liquid droplets can form on the front side of the wafer of semiconductor material; further more the pump connection opposite the gas inlet provides for a uniform flow along the underside of the wafer, around the perifery thereof and along the upperside thereof, providing for an uniform progression of isotherms in the threatment space.

Further the present invention provides an apparatus for treating a wafer of semiconductor material at a predetermined temperature with gas and/or vapour, comprising:
- a supply lock for supplying a wafer of semiconductor material;
- a treatment space in which a wafer of semiconductor material is placeable via the supply lock;
- a gas inlet for admitting gas and/or vapour into the treatment space;
- pump means for bringing the treatment space to and holding it at underpressure; and
- a table part for supporting a wafer of semiconductor material, which table part is provided with heating means, and which has a high mass relative to the surrounding part and a semiconductor wafer, and a heat capacity at least two orders of magnitude larger than the semiconductor wafer, and wherein said gas inlet for supplying the gas is provided at the underside of the table part and wherein a connection to said pump means is provided in the upper wall of said apparatus substantially opposite said gas inlet and above said table part.

Also of great importance in keeping the treatment space at a constant temperature is the constant temperature of the gas to be admitted, for which purpose control means are arranged at the gas inlet, and valves and lines are heated in a controlled manner.

Further advantages, features and details of the present invention will become apparent in the light of the following description of a preferred embodiment thereof, with reference to the annexed drawings, in which:
fig. 1 shows a diagram of an arrangement in which a preferred embodiment of the device according to the present invention is incorporated;
fig. 2 shows a diagram of the apparatus of fig. 1; and
fig. 3 shows the apparatus of fig. 2 in a second position.

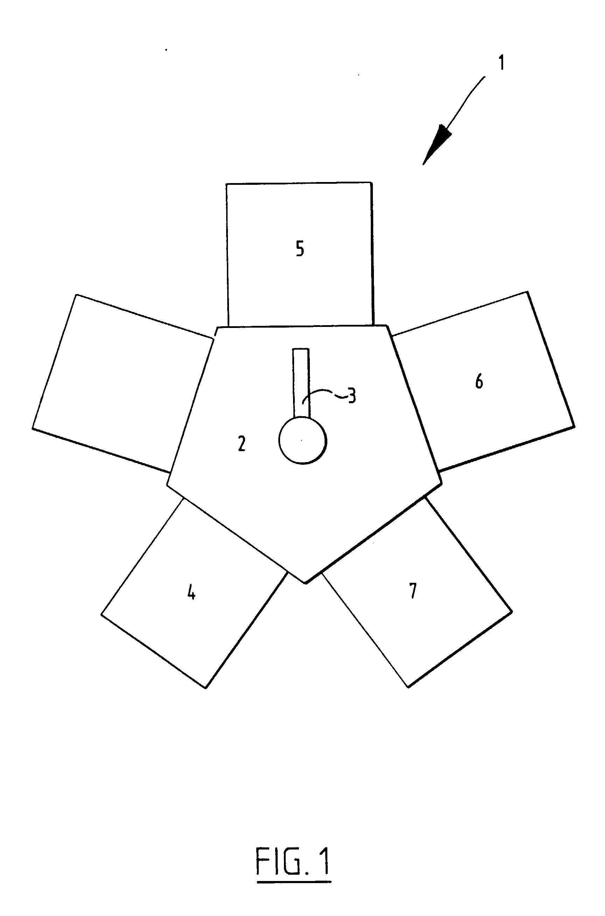

An arrangement 1 (fig. 1) comprises a transport area 2 which is held under vacuum and in which a schematically designated robot 3 is disposed for transporting wafers of semiconductor material out of a cassette 4 held under vacuum to an etching reactor 5 and an apparatus 6 according to the present invention in which a so-called silylation reaction takes place. After the said treatment wafers of semiconductor material are transported by robot 3 to an output cassette 7.

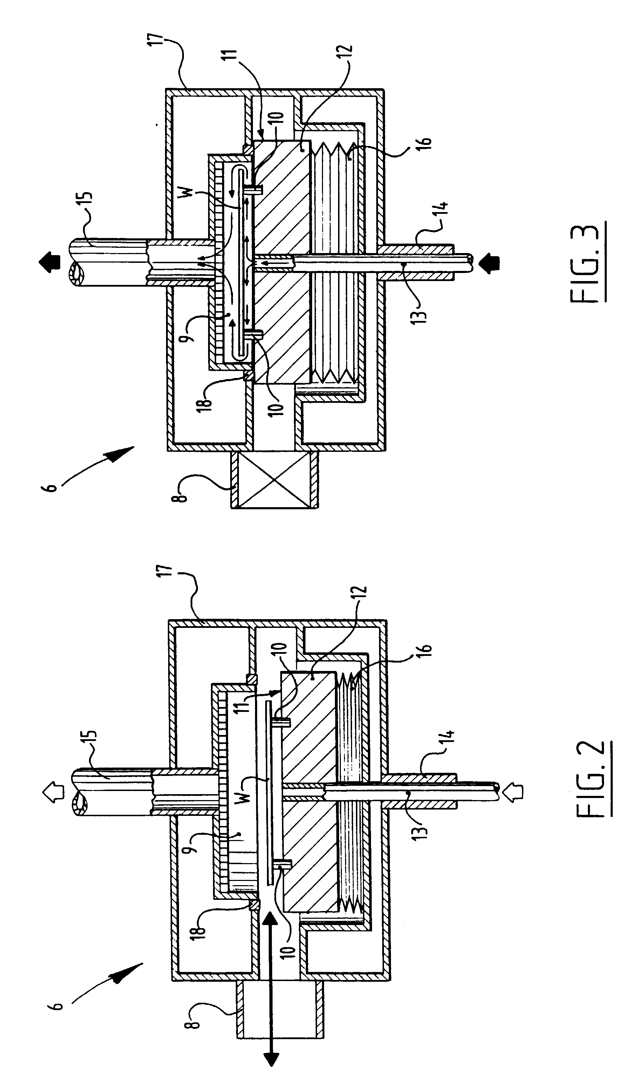

The device 6 (fig. 2, 3) comprises a supply lock 7 in which wafers of semiconductor material W are fed into a treatment space 9 and from which, in the present embodiment, they are later also discharged. The wafer of semiconductor material is placed on pins 10 which form part of a table part 11, of which a block 12 also forms part which has a considerable mass of metal, for example stainless steel, compared to the surrounding parts of the device 6.

In the present embodiment the block of metal has a diameter of 26cm and a height of 10cm, such that the heat capacity of the metal table is at least two orders of magnitude larger than a wafer of 98mm height and a diameter of 200mm. Preferably one table of stainless steel is covered with a tin layer of aluminium such as to increase thermal conduction to the wafer. The metal table is provided with fifteen heating elements of 750 watt each.

Arranged in the table part in a manner not shown are heating means - and measuring and control means for measuring and controlling the temperature -to bring the block of metal 12, the water and the treatment space 9 to the desired temperature in a temperature range of 30-250°C within a short period, for instance 10 seconds. A gas inlet 13 is further arranged through table part 11, which inlet is provided with only schematically designated temperature control means for accurate control of the temperature of the gas to be admitted. The gas is supplied on the underside of the wafer of semiconductor material W while a connection 15 to vacuum pumps is situated on the upper side of wafer W so that the admitted gas on the underside of wafer W flows radially outward and flows uniformly round the periphery of the wafer, with a diameter of for instance 200 mm, upwards to the outlet 15. After wafer W is placed on the pins 10 the whole table part is moved upward, preferably pneumatically by means of schematically designated concertina parts 16. Arranged in an uppermost portion 17 of the device 16 are sealing means 18 against which table part 11 seals in its topmost position so that treatment space 9 is brought in a short time to the desired underpressure, for instance to a desired underpressure of 1.3 x 10⁻² Pa (10⁻⁴ Torr) within 5 seconds. The device is further designed to operate to a pressure of 9 x 10⁴ Pa (700 Torr).

Initial results with the shown and described device relate particularly to the above mentioned silylation process wherein good results are obtained in the submicron region with respect to bringing about diffusion of hexamethyldisilazane and trimethyldisilazane on exposed portions of a wafer of semiconductor material so that within such submicron dimensions SiO₂ can subsequently be applied there under plasma treatment. For further details of this process reference is made to the above mentioned SPIE publication.

### Example

After a pre-silylation bake at an underpresseure of 200 Torr and a N2 flow of 20% and a time of 60 sec., a number of wafers were silylated using the above described apparatus and arangement at a temperature of 110°C, while the silylation agent (TMDS) which was introduced had a temperature of 30°C.

The uniformity of the thickness of the resist was measured to be within 1,5% at the thickness of 382-296 mm. It is important to notice that by the arrangement according to the present invention it is possible to minimize the influence of the atmospheric environment, especially moisture, as the wafers are kept under vacuum (between 1.3 x 10⁻³ Pa (10⁻⁵ Torr) and 1 x 10⁵ Pa (750 Torr)) between pretreatment and silylation (temperature 20-250°C)

The apparatus and method can be used for every type of resist that can be developed in a dry manner, especially TMDS and HMBS, and that are diffused selectively into certain parts (exposed or non-exposed) of the resist. The Desire^{R} process is an example thereof.

It is noted that in addition to the inclusion of the table part with great mass, the shown and described device is embodied such that "isotherms" in the treatment space have a uniform progression.

It is further possible in a manner not shown to supply coolant to determined locations in the upper table part in order to obtain the desired uniform temperature profiling in the treatment space.

## Claims

1. A method for treating a wafer of semiconductor material at a predetermined temperature with gas and/or vapour, comprising:
- supplying a wafer of semiconductor material in a supply lock;
- placing the wafer of semiconductor material in a treatment space via the supply lock;
- admitting gas and/or vapour into the treatment space through a gas inlet;
- bringing the treatment space to and holding it at underpressure by pump means; and
- heating the wafer of semiconductor material by heating means provided to a table part for supporting said wafer, wherein a temperature stability within 1°C is obtained in a temperature range of 30 - 250°C as the table part has a high mass and a heat capacity at least two orders of magnitude larger than a semiconductor wafer and wherein the gas is supplied through the underside of the table part and the pump means are connected through the upper wall of said apparatus, substantially opposite the gas supply and above said table part.

2. A method according to claim 1, wherein a stabilized constant temperature is reachable within 10 seconds.

3. A method according to claim 1 and 2 wherein the gas comprises a silylation agent for acting on portions of the wafer semiconductor material exposed to light.

4. An apparatus for treating a wafer of semiconductor material at a predetermined temperature with gas and/or vapour, comprising:
- a supply lock for supplying a wafer of semiconductor material;
- a treatment space in which a wafer of semiconductor material is placeable via the supply lock; - a gas inlet for admitting gas and/or vapour into the treatment space;
- pump means for bringing the treatment space to and holding it at underpressure; and
- a table part for supporting a wafer of semiconductor material, which table part is provided with heating means, and which has a high mass relative to the surrounding part and a semiconductor wafer, and a heat capacity at least two orders of magnitude larger than the semiconductor wafer, and wherein said gas inlet for supplying the gas is provided at the underside of the table part and wherein a connection to said pump means is provided in the upper wall of said apparatus substantially opposite said gas inlet and above said table part.

5. An apparatus according to claim 4, wherein the gas inlet is provided with control means for controlling the temperature of the gas to be admitted.

## Patentansprüche

1. Verfahren zur Behandlung eines Wafers aus Halbleitermaterial bei einer vorbestimmten Temperatur mit Gas und/oder Dampf, das aufweist:
- Zuführen eines Wafers aus Halbleitermaterial in eine Zufuhrschleuse;
- Plazieren des Wafers aus Halbleitermaterial in einem Behandlungsraum über die Zufuhrschleuse;
- Einlassen von Gas und/oder Dampf in den Behandlungsraum durch einen Gaseinlaß;
- Bringen des Behandlungsraumes auf einen Unterdruck und Halten desselben auf einem Unterdruck durch Pumpmittel; und
- Erwärmen des Wafers aus Halbleitermaterial durch ein Heizmittel, das an einem Tischteil zum Tragen des Wafers vorgesehen ist, wobei eine Temperaturstabilität innerhalb 1°C in einen Temperaturbereich von 30 - 250°C erhalten wird, da das Tischteil eine hohe Masse und eine Wärmekapazität, die mindestens zwei Größenordnungen größer als ein Halbleiterwafer ist, aufweist, und wobei das Gas durch die Unterseite des Tischteiles zugeführt wird und die Pumpmittel durch die obere Wand der Vorrichtung, im wesentlichen der Gaszufuhr gegenüber und oberhalb des Tischteils liegend, verbunden sind.

2. Verfahren nach Anspruch 1, bei dem eine stabilisierte konstante Temperatur innerhalb 10 Sekunden erreichbar ist.

3. Verfahren nach Anspruch 1 und 2, bei dem das Gas ein Silylierungsagens zum Wirken auf Abschnitte des Waferhalbleitermaterials, die Licht ausgesetzt sind, aufweist.

4. Vorrichtung zum Behandeln eines Wafers aus Halbleitermaterial bei einer vorbestimmten Temperatur mit Gas und/oder Dampf, die aufweist:
- eine Zufuhrschleuse zum Zuführen eines Wafers aus Halbleitermaterial;
- einen Behandlungsraum, in dem ein Wafer aus Halbleitermaterial über die Zufuhrschleuse plazierbar ist;
- einen Gaseinlaß zum Einlassen von Gas und/oder Dampf in den Behandlungsraum;
- ein Pumpmittel zum Bringen des Behandlungsraumes auf einen Unterdruck und zum Halten desselben bei einem Unterdruck; und
- ein Tischteil zum Tragen eines Wafers aus Halbleitermaterial, wobei das Tischteil mit einem Heizmittel vorgesehen ist, und wobei es eine hohe Masse relativ zu dem umgebenden Teil und einem Halbleiterwafer und eine Wärmekapazität, die mindestens zwei Größenordnungen größer als der Halbleiterwafer ist, aufweist, und wobei der Gaseinlaß zum Zuführen des Gases an der Unterseite des Tischteiles vorgesehen ist und wobei eine Verbindung zu dem Pumpmittel in der oberen Wand der Vorrichtung, im wesentlichen gegenüber dem Gaseinlaß und über dem Tischteil, vorgesehen ist.

5. Vorrichtung nach Anspruch 4, bei der der Gaseinlaß mit einem Steuermittel zum Steuern der Temperatur des einzulassenden Gases vorgesehen ist.

## Revendications

1. Procédé de traitement d'une plaquette en matériau semi-conducteur à une température prédéterminée, à l'aide de gaz et/ou de vapeur, comprenant les opérations suivantes :
- introduire une plaquette en matériau semi-conducteur dans un sas d'entrée ;
- placer la plaquette en matériau semi-conducteur dans un espace de traitement, en passant à travers le sas d'entrée ;
- introduire du gaz et/ou de la vapeur dans l'espace de traitement, par l'intermédiaire d'une entrée de gaz ;
- créer et maintenir une dépression dans l'espace de traitement, grâce à des moyens de pompage ; et
- chauffer la plaquette en matériau semi-conducteur grâce à des moyens de chauffage prévus sur une partie formant table destinée à supporter la plaquette, une stabilité en température située dans les limites de 1° étant ici obtenue dans une plage de températures de 30-250°C lorsque la partie formant table a une masse élevée et une capacité calorifique supérieure d'au moins deux ordres de grandeur à celle d'une plaquette en matériau semi-conducteur, et le gaz étant introduit par la face inférieure de la partie formant table tandis que les moyens de pompage sont branchés sur la paroi supérieure de l'appareil, sensiblement à l'opposé de l'arrivée de gaz et au-dessus de la partie formant table.

2. Procédé selon la revendication 1, dans lequel une température constante stabilisée peut être atteinte en 10 secondes.

3. Procédé selon la revendication 1 et 2, dans lequel le gaz comprend un agent de silylation destiné à agir sur des parties du matériau semi-conducteur de la plaquette exposées à la lumière.

4. Appareil de traitement d'une plaquette en matériau semi-conducteur à une température prédéterminée, à l'aide de gaz et/ou de vapeur, comprenant :
- un sas d'entrée pour l'introduction d'une plaquette en matériau semi-conducteur ;
- un espace de traitement dans lequel une plaquette en matériau semi-conducteur est susceptible d'être placée, en passant à travers le sas d'entrée ;
- une entrée de gaz pour l'introduction de gaz et/ou de vapeur dans l'espace de traitement ;
- des moyens de pompage permettant de créer et de maintenir une dépression dans l'espace de traitement ; et
- une partie formant table destinée à supporter une plaquette en matériau semi-conducteur, partie formant table qui est équipée de moyens de chauffage, et qui a une masse élevée par rapport à la partie qui l'entoure et à une plaquette en matériau semi-conducteur, et une capacité calorifique supérieure d'au moins deux ordres de grandeur à celle de la plaquette en matériau semi-conducteur, l'entrée de gaz destinée à assurer l'arrivée de gaz étant prévue sur la face inférieure de la partie formant table, tandis qu'un branchement menant aux moyens de pompage est prévu dans la paroi supérieure de l'appareil, sensiblement à l'opposé de l'entrée de gaz et au-dessus de la partie formant table.

5. Appareil selon la revendication 4, dans lequel l'entrée de gaz est équipée de moyens de commande destinés à commander la température du gaz destiné à être introduit.
